# EUROPEAN PATENT APPLICATION

(11) **EP 4 793 705 A1**
(43) Date of publication of application: **19.08.2026**
(21) Application number: 24897910.6
(22) Date of filing: 29.10.2024
(51) Int. Cl.: G03F 7/004, G03F 7/16, G03F 7/20

(54) **DRY FILM PHOTORESIST USING PHOTOSENSITIVE RESIN COMPOSITION, METHOD FOR PREPARING SAME, RESIST PATTERN, AND DISPLAY DEVICE**

(30) Priority: 29.11.2023 KR 20230169985; 23.10.2024 KR 20240145914
(71) Applicant: Kolon Industries, Inc., Seoul 07793 (KR)
(72) Inventor: JEON, Seung Han, Seoul 07793 (KR)
(74) Representative: Ter Meer Steinmeister & Partner
(86) International application number: PCT/KR2024/016669
(87) International publication number: WO 2025/116313

(57) **Abstract**

The present disclosure relates to a dry film photoresist comprising: a substrate film that does not have a separate release layer; and a photosensitive resin layer containing a cured product of a photosensitive resin composition comprising an epoxy binder, a surfactant, a cationic initiator, and a low boiling point solvent formed on the substrate film, wherein a thickness of the photosensitive resin layer is 100 µm or more, and wherein a resolution pitch (Line/Space) based on a 100 µm coating film of the photosensitive resin layer after exposure and development is 20 µm or less, and a method for preparing the same, and a resist pattern, and a display device using the same.

## Description

### [TECHNICAL FIELD]

The present disclosure relates to a dry film photoresist and a method for preparing the same, a resist pattern and a display device using the photosensitive resin composition.

### [BACKGROUND]

A photosensitive resin composition is a photoresist that can be subjected to a photolithography process, which is used in a wide range of devices for forming various electronic components such as microelectromechanical system(MEMS) components, power inductor partition walls, and electronic circuits, and is mainly used in the form of dry film photoresist(DFR), liquid photoresist ink, etc.

Also, a typical dry film photoresist is often used in applications where they are laminated onto copper clad laminates.

In this regard, in one example of the process of preparing a printed circuit board(PCB), a pretreatment process is first performed to laminate the copper clad laminate, which is the original sheet material of the PCB. In the pretreatment process, the outer layer process is performed in the order of drilling, deburring, scrubbing, etc., and the inner layer process passes through scrubbing or pickling. In the scrubbing process, a bristle brush and jet pumice are mainly used, and the pickling may pass through soft etching and pickling using 5 wt.% sulfuric acid.

In order to form a circuit on a copper clad laminate passed through a pretreatment process, a dry film photoresist (hereinafter, referred to as DFR) is generally laminated onto the copper layer of the copper clad laminate. In this process, the photoresist layer of the DFR is laminated on the copper surface while peeling off the protective film of the DFR using a laminator. Generally, the lamination is performed at a speed of 0.5~3.5 m/min, a temperature of 100~130°C, and a heating roller pressure of 10~90 psi.

The printed circuit board passed through the lamination process is left to stand for at least 15 minutes in order to stabilize the board, and then exposure is performed for the photoresist of the DFR by using a photomask having a desired circuit pattern formed thereon. When the photomask is irradiated with ultraviolet light in this process, polymerization of the photoresist irradiated with ultraviolet light is initiated by the contained photo-initiator in the irradiated area. First, the oxygen in the photoresist is consumed initially, then the activated monomer is polymerized to cause a crosslinking reaction, and then the polymerization reaction progresses while a large amount of monomer is consumed. Meanwhile, the unexposed area exists in a state where the crosslinking reaction does not progress.

Then, a developing process is performed to remove the unexposed area of the photoresist, however, in the case of alkaline developing DFR, a 0.8~1.2 wt.% potassium carbonate and sodium carbonate aqueous solution is used as a developer. In this process, the unexposed area of the photoresist is washed away by a saponification reaction between the carboxylic acid of the binder polymer and the developer in the developer, and the cured photoresist remains on the copper surface.

Next, a circuit is formed through different processes according to the inner layer and outer layer processes. In the inner layer process, a circuit is formed on the substrate through corrosion and stripping processes, while in the outer layer process, a predetermined circuit is formed through a plating and tenting process, followed by etching and solder stripping.

The above method generally receives oxygen inhibition during polymerization because the photosensitive resin composition generally contains a radical initiator.

In addition, in the case of the conventional technology according to the above method, a photosensitive resin composition is coated using a release PET as a substrate film which is advantageous for cracks, but at this time, a release treatment component such as Si is transferred from the release PET, which may cause problems in achieving stability and high resolution. That is, since the conventional technology uses a release PET as a substrate film when forming a pattern using a dry film photoresist, a release treatment component such as Si may be transferred to the photosensitive resin composition layer for forming a dry film photoresist, so that the pattern stability is reduced and limit exists for preparing a dry film photoresist having a high resolution in which the resolution pitch (line/space) based on a coating film of 100 um or more is 20 um or less.

There is also a method for preparing a dry film photoresist by a hot melt method using a photosensitive resin composition that does not contain a solvent. The hot melt method is a method of preparing a dry film photoresist by coating a composition containing a polymer resin such as an epoxy binder, an initiator, and an additive onto the substrate film while heating. Since this does not include a solvent, the mixability of respective components including the polymer resin in the photosensitive resin composition is reduced, and the heating of the photosensitive resin composition during coating is not uniformly performed, so the meltability of the photosensitive resin composition are reduced. As a result, the coating surface of the dry film photoresist is irregular, which may cause stains. In addition, if a dry film photoresist is prepared using the hot melt method as described above, there is a disadvantage that the defect rate due to stains is high in the film forming process.

### [DETAILED DESCRIPTION OF THE INVENTION]

### [Technical Problem]

It is an object of the present disclosure to provide a dry film photoresist using a solvent-type photosensitive resin composition which enables the formation of high-resolution pattern based on a coating film of 100µm or more, has high pattern stability and mechanical strength, can minimize the defect rate due to stains during the film formation process, and can reduce the residual solvent content compared to conventional ones, and a method for preparing the same.

It is another object of the present disclosure to provide a resist pattern and a display device using the photosensitive resin composition.

### [Technical Solution]

Provided herein is a dry film photoresist comprising:
a substrate film that does not have a separate release layer; and
a photosensitive resin layer containing a cured product of a photosensitive resin composition comprising an epoxy binder, a surfactant, a cationic initiator, and a low boiling point solvent formed on the substrate film,
wherein a thickness of the photosensitive resin layer is 100 µm or more, and
wherein a resolution pitch (Line/Space) based on a 100 µm coating film of the photosensitive resin layer after exposure and development is 20 µm or less.

Also provided herein is a method for preparing a dry film photoresist comprising: a step of coating a photosensitive resin composition comprising an epoxy binder, a surfactant, a cationic initiator, and a low boiling point solvent, onto a polymer substrate that does not have a separate release layer.

Further provided is a resist pattern comprising: a pattern of a photosensitive resin layer containing a cured product of a photosensitive resin composition comprising an epoxy binder, a surfactant, a cationic initiator, and a solvent,
wherein a thickness of the photosensitive resin layer is 100 µm or more, and
wherein a resolution pitch (Line/Space) based on a 100 µm coating film of the photosensitive resin layer after exposure and development is 20 µm or less.

Further provided is a display device comprising: the resist pattern, or a metal pattern formed by the resist pattern.

A dry film photoresist, a resist pattern and a display device using the photosensitive resin composition according to embodiments of the present disclosure will be described in more detail.

Prior to the description, unless explicitly stated herein, the technical terms used herein are for the purpose of describing specific embodiments only and is not intended to limit the scope of the invention.

As used herein, the singular forms "a," "an" and "the" are intended to include the plural forms as well, unless the context clearly indicates otherwise.

It should be understood that the terms "comprise," "include", "have", etc. are used herein to specify the presence of stated features, regions, integers, steps, operations, elements, and/or components, but do not preclude the presence or addition of one or more other features, regions, integers, steps, operations, elements, components, and/or groups thereof.

As used herein, the weight average molecular weight refers to a polystyrene-converted weight average molecular weight measured by gel permeation chromatography(GPC). In the process of measuring the polystyrene-converted weight average molecular weight measured by GPC, a detector and an analytical column, such as a commonly known analysis apparatus and differential refractive index detector can be used, and commonly applied temperature conditions, solvent, and flow rate can be used.

In the present disclosure, specific examples of the measurement condition are as follows: The epoxy binder resin was dissolved in tetrahydrofuran so as to have a concentration of 1.0 (w/w)% in THF (about 0.5 (w/w)% based on solid content), filtered using a syringe filter with pore size of 0.45µm, and then injected in an amount of 20µl into GPC, tetrahydrofuran (THF) was used as the mobile phase of GPC and the flow rate was 1.0 mL/min. The column configured of one Agilent Plagal 5µm Guard (7.5 x 50 mm) and two Agilent Plagal 5µm Mixed D (7.5 x 300 mm) connected in series, and the measurement was performed at 40°C by using an Agilent 1260 Infinity II system, RI Detector as a detector.

A polystyrene standard sample (STD A, B, C, D) in which polystyrene having various molecular weights was dissolved at a concentration of 0.1(w/w)% in tetrahydrofuran was filtered through a syringe filter with a pore size of 0.45µm and then injected into GPC, and the value of the weight average molecular weight (Mw) of the epoxy binder resin was determined using the calibration curve.
STD A (Mp) : 791,000 / 27,810 / 945
STD B (Mp) : 282,000 / 10,700 / 580
STD C (Mp) : 126,000 / 4,430 / 370
STD D (Mp) : 51,200 / 1,920 / 162

In the present disclosure, a solvent having a boiling point of 130°C or less is defined as a low boiling point solvent, and a solvent having a boiling point of more than 130°C is defined as a high boiling point solvent.

The present disclosure will be described in detail below.

According to an embodiment of the present disclosure, there can be provided a dry film photoresist comprising: a substrate film that does not have a separate release layer; and a photosensitive resin layer containing a cured product of a photosensitive resin composition comprising an epoxy binder, a surfactant, a cationic initiator, and a low boiling point solvent formed on the substrate film, wherein a thickness of the photosensitive resin layer is 100 µm or more, and wherein a resolution pitch (Line/Space) based on a 100 µm coating film of the photosensitive resin layer after exposure and development is 20 µm or less.

The present inventors have found through experiments that, when the dry film photoresist(DFR) of an embodiment is formed by using a photosensitive resin composition including a solution-type epoxy binder resin and also using a non-release film that does not have a separate release layer as a substrate film, it is possible to increase the resolution of the photosensitive resin layer (preferably, photosensitive resin monolayer) compared to a conventional method using a hot melt type that does not contain a solvent, thereby achieving the effect of improving adhesion and resolution, and completed the present disclosure.

In addition, since the dry film resist of the present disclosure is formed by a coating method using a photosensitive resin composition containing a solvent, an epoxy-containing dry film photoresist film having excellent coating properties without a defect rate due to stains in the film formation process can be provided in a high yield. In particular, the epoxy-containing dry film photoresist uses a non-release film, so that release treatment components such as Si are not transferred to the photosensitive resin composition layer for forming the dry film photoresist. Therefore, since the present disclosure does not include a release treatment component such as Si or a fluorine coating layer compared to a conventional product using a release PET, the pattern stability of the photosensitive resin composition layer is excellent, and the resolution of a single layer including the photosensitive resin composition can be improved more effectively, thereby achieving a high resolution. Further, in this case, a photosensitive resin layer is formed using an epoxy-containing photosensitive resin composition containing a low boiling point solvent with a boiling point of 130°C or less, and thus has better solvent removal ability than the case of using a solvent having a boiling point of more than 130°C, and prevents the generation of bubbles, so that the residual solvent content of the epoxy-containing dry film photoresist can be controlled to 2,000 ppm or less, or more than 1,000 ppm ~ 2,000 ppm or less, or 1,000 ppm or less.

Furthermore, since the dry film photoresist uses an epoxy binder and a cationic initiator, it does not receive oxygen inhibition during polymerization through exposure unlike the conventional radical initiator, so that polymerization can proceed more easily than before.

Specifically, the dry film photoresist may include a substrate film that does not have a separate release layer.

In the conventional technology, a release PET is used when forming a pattern with a dry film photoresist using a photosensitive epoxy resin composition. However, in the case of the epoxy resin composition, it is sensitive to cracks, so cracks may form in the final dry film photoresist, resulting in a defective pattern, and also the release component contained in the release PET may be transferred to the photosensitive epoxy resin composition layer, which may reduce the resolution of the pattern.

That is, in the case of general release PET, inorganic particles such as silicon are added or fluorine coating treatment is performed, but in the case of such additional treatment of PET, there is a problem that the resolution decreases due to the transfer of particles and organic substances.

In contrast, the present embodiment has the characteristic of using a non-release film that has not been subjected to a release treatment as the substrate film.

More specifically, the substrate film of an embodiment has the characteristic of using a substrate film that does not include inorganic particles or a fluorine coating layer. That is, the substrate film uses a non-release film that has not passed through any separate additional treatment. The substrate film serves as a support for the photosensitive resin layer during the preparation of the dry film photoresist, and makes it easy to handle the photosensitive resin layer having adhesiveness during exposure.

Therefore, according to an embodiment of the present disclosure, a non-release type substrate film that is subjected to a separate release treatment like a conventional case or does not include a fluorine coating layer is used, thereby ensuring high resolution and pattern stability of the dry film photoresist.

Various types of plastic films can be used as the substrate film, and examples thereof may include at least one plastic film selected from the group consisting of an acrylic film, a polyethylene terephthalate(PET) film, a triacetyl cellulose(TAC) film, a polynorbornene(PNB) film, a cycloolefin polymer(COP) film, and a polycarbonate(PC) film. The thickness of the substrate film is not particularly limited, but for example, it can be freely adjusted within the range of 0.01 µm to 1 mm.

In an embodiment, the substrate film may be a non-release PET film.

Further, the dry film photoresist may include an epoxy type photosensitive resin monolayer formed on the substrate film. The epoxy type photosensitive resin monolayer may be a photosensitive resin layer containing a cured product of a photosensitive resin composition comprising an epoxy binder, a surfactant, a cationic initiator, and a low boiling point solvent. Specifically, the photosensitive resin monolayer may include a dried product or a cured product of a coating layer of a photosensitive resin composition having a certain viscosity of a solution type including an epoxy binder, a surfactant, a cationic initiator, and a solvent. The dried product refers to a material obtained through a drying process of the photosensitive resin composition. The cured product refers to a material obtained through a curing process of the photosensitive resin composition.

The photosensitive resin layer may be a dried product or a cured product dried at a temperature of 50°C or more and 140°C or less for 25 to 50 minutes.

The dry film photoresist does not receive oxygen inhibition during polymerization through exposure using an epoxy binder and a cationic initiator, unlike the conventional radical initiator. Specifically, the cationic initiator initially reacts in the photoresist, and a polymerization reaction occurs while opening the epoxy ring. Further, the initiator efficiency can be increased through the post exposure baking process. Therefore, the above-described embodiment can increase the resolution of the photosensitive resin layer and improve adhesion and resolution.

Moreover, the dry film photoresist forms a photosensitive resin layer using a solvent-containing epoxy binder photosensitive resin composition which is not a conventional hot melt method, and thus can further improve the resolution of a single layer including a photosensitive resin composition formed on the non-release type substrate film. This is because the solubility of each component of the solvent-containing epoxy binder photosensitive resin composition increases due to the solvent, so that a dry film photoresist is formed on the substrate film without causing stains on a coating layer, thereby realizing excellent film releasability.

Further, since the solvent uses a low boiling point solvent having a boiling point of 130°C or less, the solvent is quickly evaporated in a short period of time compared to a high boiling point solvent having a boiling point of more than 130°C in the drying process, which has the advantage that the residual solvent content in the film can be minimized. Therefore, the residual solvent content in the final film can be controlled to 2,000 ppm or less, or more than 1,000 ppm to 2,000 ppm or less, or 1,000 ppm or less, thereby further improving the releasability.

Further, a photosensitive resin monolayer is made of one layer formed by one coating, and is distinguished from a laminated body of two or more layers formed by coating two or more times.

The thickness of the photosensitive resin layer is not particularly limited, but for example, it can be freely adjusted within a range of 0.01 µm to 1 mm.

More specifically, the thickness of the photosensitive resin monolayer may be 100 µm or more, or 120 µm or more, or 1000 µm or less, or 85 µm to 1000 µm, or 90 µm to 1000 µm, or 100 µm to 1000 µm, or 120 µm to 1000 µm. Such a photosensitive resin monolayer can form a fine pitch of the photosensitive resin monolayer after exposure, post exposure baking, and development through the above-mentioned method, thereby preparing a high-resolution fine circuit pattern.

Further, the thickness of the dry film photoresist is not particularly limited, but for example, it can be freely adjusted within the range of 0.01 µm to 1 mm, but may include the thickness range of the photosensitive resin monolayer. When the thickness of the dry film photoresist increases or decreases by a specific value, the physical properties measured in the dry film photoresist may also change by a specific value.

Meanwhile, the dry film photoresist may further include a protective film formed on the photosensitive resin layer.

The protective film prevents damages to the resist during handling and functions as a protective cover that protects the photosensitive resin layer from foreign substances such as dust. The protective film is laminated on the back side of the photosensitive resin layer on which the substrate film is not formed. The protective film serves to protect the photosensitive resin layer from the outside. When the dry film photoresist is applied to a post-process, it needs to be easily detached, and requires proper releasability and adhesion so that it does not peel off during storage and distribution.

Various types of plastic films can be used as the protective film, and examples thereof may include at least one selected from the group consisting of an acrylic film, a polyethylene(PE) film, a polyethylene terephthalate(PET) film, a triacetyl cellulose(TAC) film, a polynorbornene(PNB) film, a cycloolefin polymer(COP) film, and a polycarbonate(PC) film. The thickness of the protective film is not particularly limited, but for example, it can be freely adjusted within the range of 0.01 µm to 1 mm.

The method for preparing the dry film photoresist can be provided by using a coating method of a photosensitive resin composition including a solvent, rather than a hot melt method like the conventional case, on a non-release type substrate film on which inorganic particles or a fluorine coating layer are not formed.

For example, in the method for preparing the dry film photoresist, the photosensitive resin composition of an embodiment is coated once onto a substrate film such as a non-release type polyethylene terephthalate that does not contain inorganic particles or a fluorine coating layer as in the conventional case by using a conventional coating method, and then dried, and the non-release type polyethylene terephthalate film is laminated again onto the upper surface of the dried photosensitive resin monolayer to prepare a dry film. The non-release type polyethylene terephthalate film laminated on the upper surface of the photosensitive resin monolayer functions as a protective film for the epoxy photosensitive resin layer, which may affect the high resolution due to the generation of roughness.

The method of coating the photosensitive resin composition of an embodiment is not particularly limited, and for example, a method such as a coating bar may be used. Specifically, the coating may be performed by COMMA coating, but other well-known coating methods can be used.

Such a dry film photoresist may have a residual solvent content of 1000 ppm or less or 5 to 1000 ppm based on the thickness of the entire photosensitive resin layer. The residual solvent content is measured by Agilent GC-MS using a column DB-5MS-UI (60 m x 320 um x 1 um) as in Experimental Example described below, and is expressed in % units. The sample is dissolved in DMAc so as to have a concentration of 10 wt.% solution (10 wt.% in DMAc), filtered using a syringe filter with pore size of 0.45*µ*m, and then injected at 1 µl into GS-MS at 280°C. He is used as the mobile phase and the flow rate is 1 ml/min. The temperature is maintained at 40°C for 4 minutes, then increased by 10°C per minute and maintained at 320 °C for 3 minutes to measure the residual organic solvent content.

Further, a standard sample in which the solvent (MEK) was diluted in DMAc at six concentration levels is analyzed using the same GC-MS analysis method, and the peak area of the residual solvent detected in the sample is substituted into the formed calibration curve to determine the content value of the residual solvent (MEK) in the sample. In this case, the linearity of the standard calibration curve is 0.999 or more, the device detection limit of the solvent(MEK) is 0.5 ppm, and the sample is dissolved at 10wt% in DMAc for analysis. Therefore, considering the sample dilution ratio, it is possible to calculate reliable results for the residual solvent(MEK) present at 5 ppm or more in the sample using this analysis method.

Meanwhile, each component of the photosensitive resin composition of the present disclosure will be described in more detail.

The epoxy resin may be at least one selected from the group consisting of bisphenol-type epoxy resins.

According to an embodiment of the present disclosure, the epoxy resin may include at least one selected from the group consisting of bisphenol A novolac epoxy (BPA Novolac Epoxy) and biphenyl novolac epoxy resin (Biphenyl Epoxy).

The bisphenol type epoxy resin may have a weight average molecular weight of 3,000 to 5,000 g/mol and an epoxy equivalent of 200 to 300 g/eq.

The epoxy resin may be at least one selected from the group consisting of bisphenol A novolac epoxy, bisphenol A-bisphenol A diglycidyl ether polymer, and bisphenol F epoxy.

The surfactant is used in order to lower the surface tension of the epoxy resin and thus improve defoaming and coating properties.

The surfactant is contained in an amount of 0.01 to 1 part by weight, or 0.01 to 0.5 parts by weight, or 0.01 to 0.3 parts by weight, or 0.01 to 0.1 parts by weight, or 0.01 to 0.08 parts by weight, or 0.02 to 0.05 parts by weight, based on 100 parts by weight of the epoxy resin. If the content of the surfactant is less than 0.01 part by weight, there is a problem in coating properties and defoaming, and if the content is more than 1 part by weight, there is a problem that the resolution decreases.

That is, when the surfactant is added in an amount of more than 1 part by weight, or especially in an amount of 5 parts by weight or more in order to coat the solvent-type photosensitive resin composition on a release film, even if the surface tension is lowered, the resolution is reduced when the surfactant is added in excess.

As the surfactant, any one of a fluorine-based surfactant and a silicone-based surfactant can be used.

The fluorine-based surfactant may be at least one selected from the group consisting of an oligomer having a perfluoroalkyl group containing a lipophilic group, an oligomer having a perfluoroalkyl group containing a hydrophilic group, and an oligomer having a perfluoroalkyl group containing both lipophilic and hydrophilic groups.

The silicone-based surfactant may be at least one selected from the group consisting of a polyether-modified polydimethylsiloxane, a polyester-modified polydimethylsiloxane, a polyester-modified polymethylalkylsiloxane, a polyether-modified polymethylalkylsiloxane, an aralkyl-modified polymethylalkylsiloxane, and a polyether-modified siloxane.

The cationic initiator refers to a photocationic polymerization initiator that generates cationic species by irradiation with UV and active energy rays, and plays an important role in the curing of a dry film photoresist. Therefore, the cationic initiator has the characteristic of enabling the formation of a fine pattern (i.e., fine pitch) in a thick film by using a material that has sufficient performance to cure an epoxy resin and has the function of a photoacid generator with low reactivity.

According to an embodiment of the present disclosure, the cationic initiator may include at least one selected among an aromatic sulfonium complex and an iodonium cationic initiator. Specifically, the cationic initiator may be at least one selected from the group consisting of thio-p-phenylenebis(4,4'-dimethyldiphenylsulfonium) bistetrakis(pentafluorophenyl)borate (PAG-TR-21608), thio-p-phenylenebis(4,4'-dimethyldiphenylsulfonium)hexafluorophosphate, triarylsulfonium bistetrakis(pentafluorophenyl)borate, triarylsulfonium hexafluorophosphate((4-{[4-(diphenyl sulfonium)phenyl]sulfanyl}phenyl)diphenylsulfonium) hexafluorophosphate), phenyl(4-methoxyphenyl)iodonium hexafluorophosphate, N,N-dimethyl-N-benzyltrifluoromethanesulfonic acid, 4-methylphenyl(4-(2-methylpropylphenyl))iodonium hexafluorophosphate, and phenyl(4-methoxyphenyl)iodonium arsenide hexafluoride. Preferably, the cationic initiator may be thio-p-phenylenebis(4,4'-dimethyldiphenylsulfonium) bistetrakis(pentafluorophenyl)borate.

The specific type of cationic initiator has low reactivity and thus can maintain a high aspect ratio of 1:20 even in a thick film with a film thickness of 120 µm without halation phenomenon.

The cationic initiator is contained in an amount of 0.5 to 5 parts by weight based on 100 parts by weight of the epoxy resin.

If the content of the cationic initiator is less than 0.5 parts by weight, there is a problem that the degree of polymerization becomes insufficient and thus, the exposed area dissolves in the developer, and if the content is more than 5 parts by weight, the resolution of the photosensitive resin composition may decrease.

In addition, as mentioned above, in the present disclosure, a low boiling point solvent having a boiling point of 130°C or less that can dissolve each component for processability is used as the solvent. The low boiling point solvent having a boiling point of 130°C or less can achieve faster volatilization in the drying process than a high boiling point solvent having a boiling point of more than 100°C, and thus has the advantage of minimizing the residual solvent content on the film.

In this case, if the boiling point of the solvent is more than 130°C, the volatility is lower than that of the low boiling point solvent when the film is dried, so that the residual solvent remains on the film and the content of the residual solvent exceeds 2,000ppm, which causes a problem in releasing a film. Further, in order to control air bubbles generated during the film preparation process, a high boiling point solvent having a boiling point of more than 130°C can be mixed and used at 10% or less, but in this case, even if the air bubbles generated during the process can be controlled, there are difficulties in controlling the residual solvent of the film as mentioned above.

Further, even if a low boiling point solvent having a boiling point of 130°C or less is contained in the epoxy-containing photosensitive resin composition, when a high boiling point solvent having a boiling point of more than 130°C is mixed, there is a limit to lowering the residual solvent content due to the high boiling point of the high boiling point solvent, which makes it difficult to control it to 2,000 ppm or less.

Therefore, in an embodiment of the disclosure, only a low boiling point solvent having a boiling point of 130°C or less, which does not contain a high boiling point solvent is used as the solvent in the photosensitive resin composition, whereby the residual solvent content in the final film can be made lower than when using the high boiling point solvent, and the residual solvent content can be controlled to 2,000 ppm or less, or more than 1,000 ppm ~ 2,000 ppm or less, or 1,000 ppm or less.

Such a low boiling point solvent may be a low boiling point solvent having a boiling point of 130°C or less, or 120°C or less, 110°C or less, 100°C or less, 90°C or less, or 80°C or less. Further, the low boiling point solvent may be a low boiling point solvent having a boiling point of 10°C or more, 20°C or more, or 30°C or more.

Further, as the low boiling point solvent, ethyl methyl ketone (MEK or EMK), dimethoxyethane tetrahydrofuran, ethyl propionate, 1-methoxy-2-propanol, propylene glycol dimethyl ether, methyl isobutyl ketone, methanol, ethanol, and isopropyl alcohol may be used, and they may be used alone or in combination of two or more kinds.

The amount of the solvent added may be 10 to 40 parts by weight (solid content) or 20 to 30 parts by weight based on 100 parts by weight of the epoxy resin. If the solvent is used in an amount of less than 10 parts by weight, there is a problem that the yield is lowered, and if the solvent is used in an amount of more than 40 parts by weight, there is a problem that film release is not performed due to residual solvent.

In addition, an additive may be further included within a range that does not impair the purpose of the present disclosure.

For example, the additive may include various additives such as a UV absorber, a leveling agent, a curing accelerator, a filler, a reaction retarder, an anti-aging agent, an antioxidant, a pigment (dye), a plasticizer, a flame retardant, a surfactant, a dispersant, a dehydrating agent, an adhesive, and an antistatic agent.

Specifically, the additive may include a leveling agent, and the leveling agent may be polyether modified polysiloxane.

Further, the content of the additive is not particularly limited, but may be contained in an amount of 0.5 to 20 parts by weight based on 100 parts by weight of the epoxy resin.

In addition, according to another embodiment of the present disclosure, there can be provided a method for preparing a dry film photoresist comprising: a step of coating a photosensitive resin composition comprising an epoxy binder, a surfactant, a cationic initiator, and a low boiling point solvent, onto a polymer substrate that does not have a separate release layer.

The polymer substrate that does not have a separate release layer refers to the base film that does not have the separate release layer described above. Therefore, the contents related to the polymer substrate that does not have the separate release layer includes all the contents described above in an embodiment. Therefore, the low boiling point solvent is a low boiling point solvent having a boiling point of 130°C or less, and may be at least one selected from the group consisting of ethyl methyl ketone, dimethoxyethane tetrahydrofuran, ethyl propionate, 1-methoxy-2-propanol, propylene glycol dimethyl ether, methyl isobutyl ketone, methanol, ethanol, and isopropyl alcohol.

Further, the content of silicon or fluorine on the surface of the polymer substrate may be 1000 ppmw or less. The "1000 ppmw or less" means that as a separate release layer is not contained, silicon or fluorine that performs the release function is substantially not included.

The method of coating the photosensitive resin composition onto the polymer substrate that does not have a separate release layer can be performed according to a method well known in the art. For example, comma coating, die coating, etc. can be used, but are not limited thereto.

In addition, after the step of coating the photosensitive resin composition on a polymer substrate that does not have a separate release layer, a step of drying the coated photosensitive resin composition may be further included.

The step of drying the coated photosensitive resin composition may be performed by a heating means such as a hot air oven, a hot plate, a hot air circulation furnace, or an infrared heating furnace, and may be performed at a temperature of 50°C or more and 140°C or less, or 80 to 135°C or 85 to 130°C.

However, the drying may be performed for 25 to 50 minutes or 30 to 40 minutes in the above temperature range, and the process efficiency can be optimized while effectively removing the solvent without leaving air bubbles in the dried resin monolayer under the above conditions. That is, the photosensitive resin layer is a dried product or a cured product dried at a temperature of 50°C or more and 140°C or less for 25 to 50 minutes, which may be a photosensitive resin monolayer. Thereby, the thickness of the photosensitive resin layer may be 100 µm or more, and the resolution pitch (line/space) based on a 100 µm coating film of the photosensitive resin layer after exposure and development may be 20 µm or less.

Further, if the drying is performed at a temperature of more than 140°C for less than 25 minutes, the solvent and air bubbles may remain in the dried resin monolayer due to the increase in the solvent evaporation rate, which may cause a problem that the resolution pitch of the photosensitive resin monolayer increases after exposure and development, thus making it difficult to implement a fine circuit pattern. Further, if the drying is performed at a temperature of less than 50°C for more than 50 minutes, the drying time may increase excessively, which may cause a problem that the process efficiency may decrease.

The epoxy-containing dry film photoresist of the above-mentioned embodiment coats a photosensitive resin composition layer containing a low boiling point solvent epoxy binder resin having a boiling point of less than 130°C onto a non-release film, so that the release component is not transferred to the coating layer of the photosensitive resin composition, and thus a high resolution of 20 µm pitch or less can be realized, and the content of residual solvent in the film can be controlled to at least 2000 ppm or less, thereby exhibiting excellent releasability. Further, since the present disclosure uses a non-release film having excellent stability, the pattern stability of the dry film photoresist can also be ensured. The epoxy-containing dry film photoresist exhibits a film release force of 10 gf or less, and thus can be used in automated equipment.

Further provided is a resist pattern comprising a photosensitive resin pattern containing the photosensitive resin composition.

According to another embodiment of the disclosure, there can be provided a resist pattern comprising a pattern of a photosensitive resin layer containing a cured product of a coating layer of a photosensitive resin composition including an epoxy binder, a surfactant, a cationic initiator, and a solvent of the above-mentioned embodiment, wherein the thickness of the photosensitive resin layer is 100 µm or more, and the resolution pitch (line/space) of the photosensitive resin layer based on a 100 µm coating film after exposure and development is 20µm or less. The contents related to the photosensitive resin composition include all the contents described above in one embodiment.

The pattern of the photosensitive resin layer may be a photosensitive composition in the form of a pattern having an opening.

An example of a method of forming a pattern of the photosensitive resin layer may include a method of laminating the photosensitive resin layer of the dry film photoresist of the other embodiment on a substrate and then performing exposure, post-exposure baking, and development. In addition, there may be mentioned a method of laminating the photosensitive resin layer of the photosensitive element of the other embodiment on a substrate, and then performing exposure, post-exposure baking, and development.

As the substrate, a copper clad laminate, a glass substrate on which transparent electrodes such as ITO and IZO are sputtered or deposited, similar film substrate, a glass substrate coated with a dielectric paste, a silicon wafer, a glass wafer on which amorphous silicon is deposited, a silicon wafer sputtered with metal thin films such as copper, tantalum, molybdenum, and the like can be used.

The exposure process is preferably performed by using a Laser Direct exposure machine containing a light source such as UV, visible light, laser, light having a wavelength of 350 to 410 nm, particularly i-line (365 nm) or h-line (405 nm). In the case of using a laser direct exposure machine, it is possible to work under conditions where the exposure energy amount is 150 mJ/cm² or more and 600 mJ/cm² or less, and in the case of using a general lamp exposure machine, it is possible to work under the condition where the exposure energy amount is 600 mJ/cm² or less, which is useful for producing images of PCBs, lead frames, MEMS, biosensor, and other display devices.

The post exposure baking process can be performed by using an oven or a hot plate. A preferred example may be a hot air oven when using an oven, and the baking process is performed at 70 to 90°C for 10 to 60 minutes.

If the baking temperature is 90°C or more or the time is 60 minutes or more, some curing occurs in the non-exposed area, which results in a decrease in resolution, and if the baking temperature is 70°C or less and less than 10 minutes, the degree of curing is insufficient in the exposed area, which may cause the pattern to warp.

The developing process can be performed by a dipping method, a showering method, a spraying method, a brushing method, etc. As a developer, unlike a typical photoresist developer, an organic developer including an organic solvent such as PGMEA is used instead of an alkaline developer. As such organic developer, organic solvents such as methyl-2-hydroxyisobutyrate, ethylene glycol methyl ether acetate, 2-methoxy-1-methylethyl ester, propylene acetate, dibutyl ether, ethylene glycol monomethyl ether, ethylene glycol dimethyl ether, propylene glycol monomethyl ether acetate(PGMEA), and propylene glycol dimethyl ether can be used, and these can be used alone or in combination of two or more kinds. According to a preferred embodiment, the developer may be PGMEA.

Therefore, the photosensitive resin layer may be developed with one or more organic solvents selected from the group consisting of methyl-2-hydroxy isobutyrate, ethylene glycol methyl ether acetate, 2-methoxy-1-methylethyl ester, propylene acetate, dibutyl ether, ethylene glycol monomethyl ether, ethylene glycol dimethyl ether, and propylene glycol dimethyl ether.

After the development process using the organic developer, a rinsing process may be further performed with IPA (isopropyl alcohol). In addition, after the rinsing process, a baking process may be further performed in an oven at 70 to 90°C for 10 to 60 minutes to remove the remaining IPA.

When the dry film photoresist of the other embodiment has a protective film on the photosensitive resin layer, a process of removing the protective film may be further performed before a process of laminating the photosensitive resin layer on a circuit board or a substrate for preparing display devices.

Further, when the dry film photoresist of the other embodiment has a polymer substrate or substrate film laminated on one side of the photosensitive resin layer, a process of removing the polymer substrate or substrate film may be further performed before the exposure process.

According to another embodiment of the disclosure, a display device comprising the resist pattern, or a metal pattern formed by the resist pattern may be provided. Further, the resist pattern or the metal pattern formed by the resist pattern may be included in the circuit board.

It may be a resist pattern comprising a pattern of a photosensitive resin layer including the photosensitive resin composition of one embodiment.

The pattern of the photosensitive resin layer may be a pattern-shaped photosensitive composition having an opening.

Examples of a method of forming the photosensitive resin pattern may include a method of coating the photosensitive resin composition of the dry film photoresist of the other embodiment on a substrate, laminating the photosensitive resin layer through drying using the above-mentioned method, and then performing exposure, baking, and development. In addition, there may be mentioned a method of laminating the photosensitive resin layer of the photosensitive element according to the other embodiment on a substrate, and then performing exposure and development.

Therefore, after forming a photosensitive resin layer through the step of drying the photosensitive resin composition, the method may further include a step of exposing and developing the photosensitive resin layer.

The photosensitive resin layer can realize a dry film photoresist that simultaneously satisfies the characteristics of a thin line adhesion, which is the minimum line width of a photosensitive resin monolayer after exposure and development, being 5µm or less.

The exposure process can be performed using a light source well known in the art, such as UV, visible light, or laser, and particularly Laser Direct including a light source with a wavelength of 375 nm or less can be used. For a more specific example, the exposure process can be irradiated with an exposure dose of 200 mJ/cm².

Further, a post exposure baking process may be performed to increase the efficiency of the cationic initiator. The post exposure baking process may use a hot air oven or a hot plate. As a preferred example, when a hot air oven is used, the baking process may be performed in the oven at 70~90°C for 10~60 minutes.

The developing process can be performed by a dipping method, a showering method, a spraying method, a brushing method, etc. As a developer, unlike a typical photoresist developer, an organic developer including an organic solvent such as PGMEA is used instead of an alkaline developer. As such organic developer, organic solvents such as methyl-2-hydroxyisobutyrate, ethylene glycol methyl ether acetate, 2-methoxy-1-methylethyl ester, propylene acetate, dibutyl ether, ethylene glycol monomethyl ether, ethylene glycol dimethyl ether, propylene glycol monomethyl ether acetate(PGMEA), and propylene glycol dimethyl ether can be used, and these can be used alone or in combination of two or more kinds. According to a preferred embodiment, the developer may be PGMEA.

Therefore, according to other embodiments, a circuit board or MEMS, semiconductor packaging, and a biosensor, or a display device comprising a resist pattern, or a metal pattern formed by the resist pattern of the other embodiment can be provided. The details concerning the resist pattern includes all the contents described above in the other embodiment.

The specific contents concerning the circuit board or the purpose and device are not particularly limited, and various technical configurations known in the art can be applied without limitation.

The metal pattern can be formed by the above-mentioned resist pattern. Specifically, the metal pattern can be formed by etching or plating through the openings included in the above-mentioned resist pattern. That is, the metal pattern may include a lower metal remaining after etching the lower metal of the resist pattern through the opening included in the resist pattern, or a metal plated in the opening included in the resist pattern.

Specifically, for example, the lower substrate exposed by the above-mentioned resist pattern is etched or plated, thereby making it possible to prepare a partition wall of power inductor, a microelectromechanical system (MEMS) component, an electronic circuit, a conductor pattern, a printed wiring board, a lead frame, an ITO electrode, a black mattress, a semiconductor bump, etc. If necessary, after the etching or plating, the resist pattern can be peeled and removed from the substrate using an aqueous solution having a stronger acidity than the developer. For example, a resist pattern including a cured product of an epoxy binder can be peeled and removed from the substrate using an aqueous sulfuric acid solution.

The applications include use as a high-resolution PR in MEMS, or as an insulating film or passivation film in biochips, sensors, and semiconductor packaging.

More specifically, the resist pattern can be applied to microelectromechanical system (MEMS) components.

Thereby, the dry film photoresist of the present disclosure can be used to form a circuit having a fine line width through a subsequent conventional etching/plating process, and to maximize productivity in producing images in high-resolution MEMS as well as PCB lead frames, PDPs, other display devices, semiconductor devices, etc. through a known process.

### [Advantageous Effects]

According to the present disclosure, when providing an epoxy-containing dry film photoresist, since a non-release film (e.g., non-release PET) without a separate release layer is used as a substrate film, it can ensure the pattern stability of the dry film photoresist, and exhibits a film release force of 10 gf or less, so that it can be used in automated equipment. Also, in the present disclosure, a solvent-type epoxy binder-containing photosensitive resin composition (i.e., PR) is used instead of a solvent-free hot melt type, which can improve the coating property in the film forming process, reduce the stain defect rate, and improve the quality while providing an epoxy-containing dry film photoresist with a high yield.

In addition, since the present disclosure forms a dry film photoresist pattern through a drying process using a low boiling point solvent having a boiling point of 130°C or less in the solvent-type epoxy binder-containing photosensitive resin composition, the solvent can be removed in a short period of time in the drying process, thereby reducing the residual solvent content in the film as much as possible. Therefore, the present disclosure can more effectively control the residual solvent content of the dry film photoresist, and for example, can control the residual solvent content to be less than the conventional level, that is, 2000 ppm or less, 1000 to 2000 ppm or less, or 1000 ppm or less.

### [BRIEF DESCRIPTION OF THE DRAWING]

FIG. 1 is a schematic diagram illustrating a process for preparing a dry film photoresist according to an embodiment of the present disclosure.
FIG. 2 shows an electron microscope photograph of the pattern after development to evaluate the resolution of Examples and Comparative Examples.
FIG. 3 shows the release values and appearance photographs at the time of releasing a film to evaluate the yields of Examples and Comparative Examples.

### [DETAILED DESCRIPTION OF THE EMBODIMENTS]

Hereinafter, the actions and effects of the invention will be described more specifically with reference to specific examples of the present disclosure. However, these examples are presented only as the illustrations of the invention, and the scope of the right of the invention is not determined thereby.

### Example 1

A photosensitive resin composition containing 0.05 parts by weight of surfactant (Flow 425 product from Evonik), 1 part by weight of cationic initiator, and 25 parts by weight of solvent based on 100 parts by weight of BPA no-block epoxy binder (KEB-3165M80 from Kolon Industries) was prepared.
Cationic initiator: PAG-TR-21608, thio-p-phenylenebis(4,4'-dimethyldiphenylsulfonium) bistetrakis(pentafluorophenyl) borate
Solvent: methyl ethyl ketone

The photosensitive resin composition was placed in a stirrer and stirred at 600 rpm for 3 hours.

After stirring, natural defoaming was performed for 12 hours or more, and vacuum defoaming was performed at a pressure of 0.095 MPa for 1 hour.

After defoaming, filtration was performed using a 25µm filter, and coating was performed. The viscosity of the sample was 3,000~4,000 cP.

Then, the resin composition was subjected to COMMA coating on a PET substrate film (CT505 from Kolon Industries) with a thickness of 36µm to a thickness of 120µm, and the coating was performed over an area of a width of 450 cm and a length of 100 m in total. After coating, drying was performed at a temperature of 130°C for 40 minutes, and the obtained photosensitive resin composition was applied once on a PET film without a release treatment method using a COMMA coater, and dried in a dryer at 130°C for 40 minutes to form a photosensitive resin layer. The total thickness of the photosensitive resin layer after drying was 120µm. In addition, the residual solvent content of the photosensitive resin layer was set to 62 ppm by the above method.

A PET protective film was laminated on the photosensitive resin layer after drying was completed to prepare a dry film photoresist. The same protective film as above was used as the PET substate film.

### Example 2

A dry film photoresist was prepared under the same conditions as in Example 1, but the drying time was adjusted to 30 minutes. As a result, the residual solvent content of the dry film photoresist was 1271 ppm.

### Example 3

A dry film photoresist was prepared in the same manner as in Example 1, except that phenyl(4-methoxyphenyl)iodonium hexafluorophosphate was used instead of PAG-TR-21608 as a cationic initiator in the photosensitive resin composition of Example 1. As a result, the residual solvent content of the dry film photoresist was 73 ppm.

### Example 4

A dry film photoresist was prepared in the same manner as Example 1, except that the surfactant was used in an amount of 1 part by weight in the photosensitive resin composition of Example 1. As a result, the residual solvent content of the dry film photoresist was 79 ppm.

### Comparative Example 1

Under the same conditions as in Example 1, the sample was prepared and coated with a solvent-free hot melt composition.

Specifically, the photosensitive resin composition of Example 1 was stirred, excluding the solvent from its composition, and the solid (solvent-free) mixture was heated to 160°C, and coated on a non-release PET with a thickness of 36 µm to a thickness of 120 µm to prepare a dry film photoresist. As a result, the residual solvent content of the dry film photoresist was the detection limit or less (5 ppm or less).

### Comparative Example 2

A dry film photoresist was prepared in the same manner as in Example 1, except that the drying time was adjusted to 20 minutes. As a result, the residual solvent content of the dry film photoresist was 2,520 ppm.

### Comparative Example 3

A dry film photoresist was prepared in the same manner as in Example 1, except that a 36 µm thick silicone release-treated PET film was used as a substrate film and a hot melt type photosensitive resin composition containing no solvent of Comparative Example 1 was coated on the silicone release-treated PET film.

At this time, the silicone release-treated PET film is a polyethylene terephthalate film in which a release layer was formed on one side of a support film using a silicone resin by an ILC (in-line coating) method. As a result, the residual solvent content of the dry film photoresist was the detection limit or less (5 ppm or less).

### Comparative Example 4

A dry film photoresist was prepared in the same manner as in Example 1, except that the 36 µm thick silicone release-treated PET film of Comparative Example 3 was used as the substrate film. As a result, the residual solvent content of the dry film photoresist was 78 ppm.

### Comparative Example 5

A dry film photoresist was prepared in the same manner as in Example 1, except that the 36 µm thick silicone release-treated PET film of Comparative Example 3 was used as the substrate film and the surfactant was used in an amount of 5 parts by weight in the photosensitive resin composition of Example 1. As a result, the residual solvent content of the dry film photoresist was 188 ppm.

### Comparative Example 6

A dry film photoresist was prepared in the same manner as in Example 1, except that a 36 µm thick silicone release-treated PET film was used as the substrate film and the drying time was adjusted to 20 minutes. As a result, the residual solvent content of the dry film photoresist was 2,820 ppm.

### Comparative Example 7

A dry film photoresist was prepared in the same manner as in Example 1, except that a 36 µm thick silicone release-treated PET film was used as the substrate film, the surfactant was used in an amount of 5 parts by weight in the photosensitive resin composition of Example 1, and the drying time was adjusted to 20 minutes. As a result, the residual solvent content of the dry film photoresist was 2,975 ppm.

### Comparative Example 8

A dry film photoresist was prepared in the same manner as in Example 1, except that a 36 µm thick silicone release-treated PET film was used as the substrate film, the surfactant was used in an amount of 1.5 parts by weight in the photosensitive resin composition of Example 1, and the drying time was adjusted to 20 minutes. As a result, the residual solvent content of the dry film photoresist was 2,670 ppm.

### Comparative Example 9

A dry film photoresist was prepared in the same manner as in Example 1, except that in the photosensitive resin composition of Example 1, methyl ethyl ketone and PGMEA were mixed and used in a ratio of 3:1. As a result, the residual solvent content of the dry film photoresist was 3,175 ppm, exceeding 2,000 ppm.

### <Experimental Example>

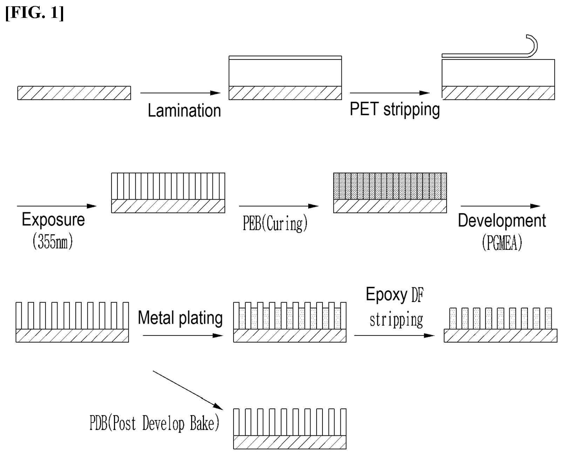

A laminated body containing a dry film photoresist was formed using the process of FIG. 1, and then the physical properties were evaluated using the following method. The results are shown in Table 1 below.

### (Process for preparing sample)

The protective film on one side of the dry film photoresist prepared in Examples and Comparative Examples was removed, and roll lamination (80~90°C, 4.0Kgf/cm²) was performed on the substrate.

After removing the PET film on the other side, it was exposed with an exposure device with a wavelength of 355nm.

After exposure, the exposed film was placed in a convection oven and baked at 80~85°C for 15~30 minutes.

After PEB (Post Exposure Bake), the film was developed in PGMEA for 10~20 minutes and rinsed with IPA for 10 minutes.

Then, the film was baked in an oven at 80°C for 10 minutes to remove the remaining IPA.

After that, if necessary, the remaining film was heat-treated at the time of use, and if removal was required, it was peeled off in a 98% sulfuric acid solution.

### 1. Yield

In the case of yield, if stains (line stains, cracks, air bubbles, foreign substances) and a thickness deviation of 5% or more occurred, it was treated as defective.
○: The area of the section where a stain occurs is 10m or less (yield: 90%) / △: The area of the section where a stain occurs is more than 10 m ~ 20 m or less (yield: less than 90% ~ 80% or more) / X: The area of the section where a stain occurs is more than 20 m (yield: less than 80%)

### 2. Resolution

For the resolution, the pattern was evaluated at a wavelength of 355 nm using a 1:1 line & space mask, and analyzed by SEM.

That is, after the PET film, which was the support for the dry film photoresist, was removed from the laminated body passed through the process of FIG. 1, and then irradiated with ultraviolet rays of 355 nm wavelength at an exposure dose of 200 mJ/cm² using an LDI (Laser Direct imaging system) exposure machine (Model: Paragon Ultra80), and then left for 10 minutes. Then, the film was heat-cured in a convection oven at 85°C for 20 minutes.

The heat-cured film was then dipped in PGMEA (propylene glycol monomethyl ether acetate) at 30°C and developed for 20 minutes while performing sonication (600MW, 1MHz).

After development, the film was rinsed in IPA for 10 minutes and dried in a conventional oven for 10 minutes.

In the laminated body after completing the process, the minimum value of the gap between the photosensitive resin layers was measured using a ZEISS AXIOPHOT Microscope, and evaluated as a 1:1 resolution. It can be evaluated that as this value is smaller, the 1:1 resolution value is better.

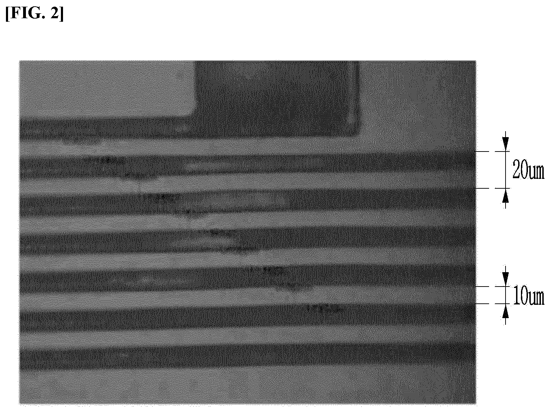

After that, the results were evaluated by the following method based on the image in FIG. 2.

FIG. 2 shows an electron microscope photograph (evaluation standard) of the pattern after development to evaluate the resolution of Examples and Comparative Examples. At this time, the resolution was evaluated as follows based on the pattern interval of 20 um as in FIG. 2. In addition, the pattern wall and space interval in FIG. 2 are each 10 um.
○ : No pattern abnormality at line + space size of 20 um or less / △ : No pattern abnormality at line + space size of 21~23 um / X : Not open and residue, line collapse occurred at 20~23 um

### 3. Film releasability

In the case of film releasability, a film was prepared using a peel test of 25 X 80 nm, and released at 90 degrees using 3M Scotch tape (equipment MICRO TXA-40 / speed 20 mm/sec).

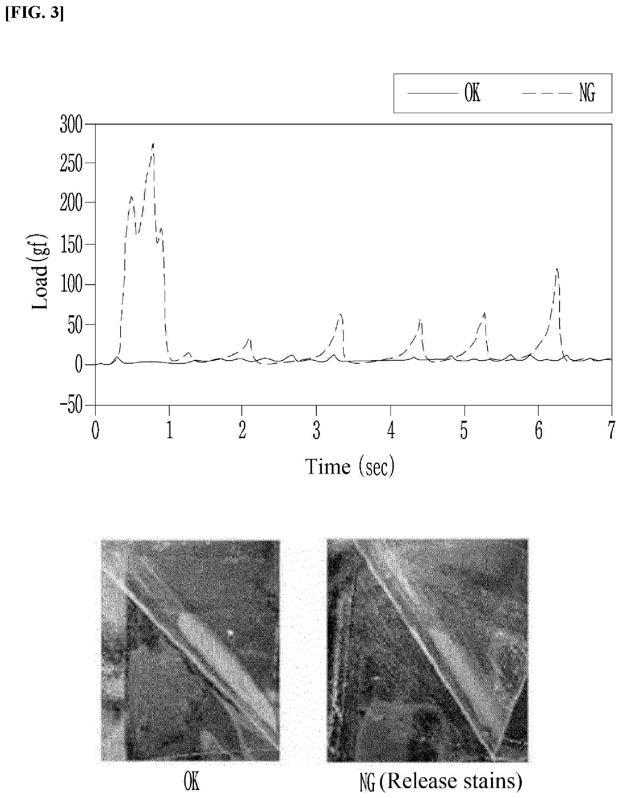

Then, the results were evaluated using the following method based on the image in FIG. 3. FIG. 3 shows the release values and appearance photographs (evaluation criteria) at the time of releasing a film to evaluate the yields of Examples and Comparative Examples.
⊚ : load of 5 gf or less, ∘ : load of 10 gf or less, X : load of more than 10 gf (excluding the initial film lifting section, 0~1 sec), when the load exceeds 10 gf, film release stains occur

### 4. Residual organic solvent content

The residual solvent content was measured by Agilent GC-MS using a column DB-5MS-UI (60 m x 320 um x 1 um), and was expressed in % units. The sample was dissolved in DMAc so as to have a concentration of 10 wt.% solution (10 wt.% in DMAc), filtered using a syringe filter with pore size of 0.45µm, and then injected at 1 µl into GS-MS at 280°C. He was used as the mobile phase and the flow rate was 1 ml/min. The temperature was maintained at 40°C for 4 minutes, then increased by 10°C per minute and maintained at 320°C for 3 minutes to measure the residual organic solvent content.

Further, a standard sample in which the solvent (MEK) was diluted in DMAc at six concentration levels was analyzed using the same GC-MS analysis method, and the peak area of the residual solvent detected in the sample was substituted into the formed calibration curve to determine the content value of the residual solvent(MEK) in the sample. In this case, the linearity of the standard calibration curve was 0.999 or more, the device detection limit of the solvent(MEK) was 0.5 ppm, and the sample was dissolved at 10 wt% in DMAc for analysis. Therefore, considering the sample dilution ratio, it is possible to calculate reliable results for the residual solvent(MEK) present at 5 ppm or more in the sample using this analysis method.

**[Table 1]**

| | | Substrate film | Coating method | Resolution (20 um Pitch) | Film release | Residual organic solvent content | Yield |
|---|---|---|---|---|---|---|---|
| Example | 1 | A | C | ○ | ⊚ | 62 ppm | ○ |
| | 2 | A | C | ○ | ○ | 1,271 ppm | ○ |
| | 3 | A | C | ○ | ⊚ | 73 ppm | ○ |
| | 4 | A | C | ○ | ⊚ | 79 ppm | ○ |
| Comparative Example | 1 | A | D | X | ○ | 5 ppm or less | X |
| | 2 | A | C | X | X | 2,520 ppm | ○ |
| | 3 | B | D | X | ○ | 5 ppm or less | X |
| | 4 | B | C | X | ○ | 78 ppm | X |
| | 5 | B | C | X | ○ | 188 ppm | ○ |
| | 6 | B | C | X | ○ | 2,820 ppm | X |
| | 7 | B | C | X | ○ | 2,975 ppm | ○ |
| | 8 | B | C | Δ | ○ | 2,670 ppm | Δ |
| | 9 | A | C | X | X | 3,175 ppm | ○ |
| Note) | | | | | | | |
| 1) Substrate film - non-release PET: A, release PET (silicon release-treated PET film): B | | | | | | | |
| 2) Coating method - solvent type: C, hot melt type: D | | | | | | | |

According to the results of Table 1, Examples 1 to 4 could realize higher resolution than Comparative Examples, and was improved in both film releasability and yield.

In contrast, in Comparative Examples 1 to 9, a dry film photoresist containing a photosensitive resin layer was formed by a hot melt method instead of a solution-type photosensitive resin composition as in the present application (Comparative Examples 1 and 3), or the release component was separately treated on the substrate film (Comparative Examples 3 to 8), so that high resolution, film releasability and yield could not be satisfied. In particular, Comparative Examples 1 and 3 had low yields, and thus could not achieve high resolution.

Also, in Comparative Example 2, the drying time of the photosensitive resin coating layer was shorter than the drying time range of the present application, and the residual solvent content exceeded 2000 ppm, whereby the film releasability was poor due to release stains during release, and it was impossible to achieve high resolution.

Furthermore, in Comparative Example 3, a silicone release-treated PET film and a hotmelt type photosensitive resin composition not containing a solvent were used, so the residual solvent content exceeded 2000 ppm as in Comparative Example 2, resulting in a reduced yield and making it impossible to achieve high resolution.

In addition, in Comparative Examples 5 and 7, in order to coat the solvent-type photosensitive resin composition on the release film, the surfactant was added in an excessive amount (5 parts by weight or more) to lower the surface tension, which resulted in a decrease in resolution.

That is, in Comparative Examples 5 and 7, when the photosensitive resin composition containing the solvent was coated on the silicone release-treated PET film, the surfactant was added in an excessive amount(5 parts by weight or more) to lower the surface tension. However, in Comparative Examples 5 and 7, the resolution was rather reduced due to the excessive addition of surfactant. In particular, the residual solvent content of Comparative Example 7 was 2975 ppm, which was excessive compared to that of Examples, thereby making it impossible to achieve high resolution.

In Comparative Example 6, even though the surfactant content was lowered in the solvent type to prepare a dry film photoresist, as the release film was used as the substrate film, the content of the residual organic solvent exceeded 2000 ppm as in Comparative Example 2, and in particular, the yield was reduced, and silicon release treatment components were transferred to the photosensitive resin layer, which caused problems that the pattern stability was poor and it was difficult to achieve high resolution.

In Comparative Example 8, the surfactant was used in an amount of 1.5 parts by weight, which was less than the excessive 5 parts by weight, but both the resolution and yield were lower than those of Examples 1 and 2.

In addition, in Comparative Example 9, even if it contained a low boiling point solvent (methyl ethyl ketone), the residual solvent content exceeded 2000 ppm due to the mixing of a high-boiling point solvent (PGMEA), the film releasability was poor due to release stains during release, and it was impossible to achieve high resolution.

## Claims

1. A dry film photoresist comprising:
a substrate film that does not have a separate release layer; and
a photosensitive resin layer containing a cured product of a photosensitive resin composition comprising an epoxy binder, a surfactant, a cationic initiator, and a low boiling point solvent formed on the substrate film,
wherein a thickness of the photosensitive resin layer is 100 µm or more, and
wherein a resolution pitch (Line/Space) based on a 100 µm coating film of the photosensitive resin layer after exposure and development is 20 µm or less.

2. The dry film photoresist according to claim 1,
wherein the substrate film does not contain an inorganic particle or a fluorine coating layer, and comprises at least one selected from the group consisting of an acrylic film, a polyethylene terephthalate(PET) film, a triacetyl cellulose(TAC) film, a polynorbornene(PNB) film, a cycloolefin polymer(COP) film, and a polycarbonate(PC) film.

3. The dry film photoresist according to claim 1,
wherein the photosensitive resin layer is dried product or cured product that has been dried at a temperature of 50°C or more and 140°C or less for 25 to 50 minutes.

4. The dry film photoresist according to claim 1,
wherein a residual solvent content is 2000 ppm or less.

5. The dry film photoresist according to claim 1,
wherein the photosensitive resin composition contains:
0.01 to 1.00 parts by weight of the surfactant,
0.5 to 5.0 parts by weight of the cationic initiator, and
10 to 40 parts by weight of the solvent,
based on 100 parts by weight of the epoxy binder.

6. The dry film photoresist according to claim 1,
wherein the epoxy binder comprises a bisphenol-type epoxy resin.

7. The dry film photoresist according to claim 1,
wherein the cationic initiator comprises at least one selected among an aromatic sulfonium complex salt and an iodonium cationic initiator.

8. The dry film photoresist according to claim 7,
wherein the cationic initiator is at least one selected from the group consisting of thio-p-phenylenebis(4,4'-dimethyldiphenylsulfonium)bistetrakis(pentafluorophenyl) borate, thio-p-phenylenebis(4,4'-dimethyldiphenylsulfonium)hexafluorophosphate, triarylsulfonium bistetrakis(pentafluorophenyl)borate, triarylsulfonium hexafluorophosphate, phenyl(4-methoxyphenyl)iodonium hexafluorophosphate, N,N-dimethyl-N-benzyltrifluoromethanesulfonic acid, 4-methylphenyl(4-(2-methylpropylphenyl))iodonium hexafluorophosphate, and phenyl(4-methoxyphenyl)iodonium arsenic hexafluoride.

9. The dry film photoresist according to claim 1,
wherein the low boiling point solvent is a low boiling point solvent having a boiling point of 130°C or less, and is at least one selected from the group consisting of ethyl methyl ketone, dimethoxyethane tetrahydrofuran, ethyl propionate, 1-methoxy-2-propanol, propylene glycol dimethyl ether, methyl isobutyl ketone, methanol, ethanol, and isopropyl alcohol.

10. A method for preparing a dry film photoresist comprising:
coating a photosensitive resin composition comprising an epoxy binder, a surfactant, a cationic initiator, and a low boiling point solvent, onto a polymer substrate that does not have a separate release layer.

11. The method for preparing a dry film photoresist according to claim 1,
wherein the low boiling point solvent is a low boiling point solvent having a boiling point of 130°C or less, and is at least one selected from the group consisting of ethyl methyl ketone, dimethoxyethane tetrahydrofuran, ethyl propionate, 1-methoxy-2-propanol, propylene glycol dimethyl ether, methyl isobutyl ketone, methanol, ethanol, and isopropyl alcohol.

12. The method for preparing a dry film photoresist according to claim 10,
wherein the content of silicon or fluorine on the surface of the polymer substrate is 1000 ppmw or less.

13. A resist pattern comprising:
a pattern of a photosensitive resin layer containing a cured product of a photosensitive resin composition comprising an epoxy binder, a surfactant, a cationic initiator, and a solvent,
wherein a thickness of the photosensitive resin layer is 100 µm or more, and
wherein a resolution pitch (Line/Space) based on a 100 µm coating film of the photosensitive resin layer after exposure and development is 20 µm or less.

14. A display device comprising: the resist pattern according to claim 13, or a metal pattern formed by the resist pattern according to claim 12.
